Europäisches Patentamt

European Patent Office

Office européen des brevets

(11) Veröffentlichungsnummer: **0 463 297 A1**

# EUROPÄISCHE PATENTANMELDUNG

(21) Anmeldenummer: **91104586.2**

(22) Anmeldetag: **23.03.91**

(51) Int. Cl.5: **H01L 21/60**, H01L 23/13

(30) Priorität: **23.06.90 DE 4020048**

(43) Veröffentlichungstag der Anmeldung:
**02.01.92 Patentblatt 92/01**

(84) Benannte Vertragsstaaten:
**BE FR GB IT NL SE**

(71) Anmelder: **ANT Nachrichtentechnik GmbH**
**Gerberstrasse 33**
**W-7150 Backnang(DE)**

(72) Erfinder: **Kuke, Albrecht, Dr.-Phys.**
**Nelkenweg 2**
**W-7159 Auenwald(DE)**
Erfinder: **Hauer, Heiner, Dipl.-Ing.**
**Frühlingshalde 1**
**W-7012 Fellbach(DE)**
Erfinder: **Spatscheck, Thomas, Dipl.-Ing.**
**Ahornweg 17**
**W-7150 Backnang(DE)**

(54) **Anordnung aus Substrat und Bauelement und Verfahren zur Herstellung.**

(57) Bei einer Anordnung aus Substrat und Bauelement bei der das Bauelement mittels eines Lötvorganges mit dem Substrat fest verbunden wird, hat entweder am Substrat (2) an der für das Bauelement vorgesehenen Stelle oder am Bauelement (3) selbst oder sowohl am Bauelement (3) als auch am Substrat (2) Vorsprünge (5) die sich außerhalb der zu verlötenden Flächen (1,1') befinden und deren Ausdehnung senkrecht zur Substratebene durch den zwischen Substrat und Bauelement geforderten Abstand ($h_s$) bestimmt ist.

Fig. 1

Die vorliegende Erfindung betrifft eine Anordnung aus Substrat und Bauelement, wobei das Bauelement mittels eines Lötvorganges mit dem Substrat fest verbunden wird.

Bei der Montage von Bauelementen auf Substrate werden nach dem Stand der Technik Bauelemente mit metallisierten Flecken, die gleichzeitig zur elektrischen Kontaktierung und zur mechanischen Befestigung dienen, auf entsprechende Metallisierungsflächen auf dem Substrat montiert. Dabei ist entweder auf den Metallisierungsflächen des Substrates oder des Bauelementes Lot aufgebracht, sogenannte Lot-Bumps. Bei der Montage werden Substrat und das Bauelement über die Schmelztemperatur des Lotes erwärmt,wobei die Lot-Bumps aufschmelzen und im flüssigen Zustand durch ihre Oberflächenspannung die Metallisierungsflächen des Bauelements zu denen des Substrates lateral justieren. Im Gegensatz zu dieser lateralen Justierung des Bauelements ist die nach dem Erstarren erreichte Höheneinstellung, d.h. der Abstand zwischen Bauelement und Substrat, von vielerlei Faktoren abhängig und daher nicht präzise einstellbar. Insbesondere spielen hier die Lotdicke, die Fleckgröße, die Benetzbarkeit der Metallisierung, die Oberflächenspannung des Lotes, die Temperatur und die Abkühlgeschwindigkeit eine Rolle, wobei sich die genannten Faktoren auch gegenseitig beeinflussen können. Will man wie in der Vergangenheit mit dieser Technik nur Bauelemente mit ausschließlich elektronischen Funktionen montieren, so spielt der Höhenabstand zwischen Bauelement und Substrat nur eine untergeordnete Rolle. Dagegen bei der Montage von optoelektronischen Bauteilen wie zum Beispiel einem Laser, der zu einer auf dem gleichen Substrat befindlichen Lichtleitfaser oder zu einem Streifenwellenleiter montiert werden soll, müssen jedoch alle Koordinaten, also auch die Höhe, mit äußerster Präzision eingestellt werden.

Aufgabe der vorliegenden Erfindung ist es, eine Anordnung aus Substrat und darauf zu befestigendem Bauelement vorzuschlagen, die es gestattet, die Einstellung der Lage des Bauelements sowohl parallel als auch senkrecht zur Ebene des Substrats wesentlich zu präzisieren. Eine weitere Aufgabe der Erfindung besteht darin, Verfahren zur Herstellung einer solchen Anordnung anzugehen.

Die gestellte Aufgabe wird erfindungsgemäß gelöst dadurch, daß entweder am Substrat an der für das Bauelement vorgesehenen Stelle oder am Bauelement selbst oder sowohl am Bauelement als auch am Substrat Vorsprünge vorgesehen sind, die sich außerhalb der zu verlötenden Flächen befinden und deren Ausdehnung senkrecht zur Substratebene durch den zwischen Substrat und Bauelement geförderten Abstand bestimmt ist. Eine vorteilhafte Weiterbildung ist dadurch gekennzeichnet, daß an den den Vorsprüngen gegenüberliegenden Stellen jeweils Vertiefungen vorgesehen sind in die die Vorsprünge eingreifen.

Eine Weiterbildung der Erfindungen zeichnet sich dadurch aus, daß am vorbereiteten Substrat oder Bauelement angebrachte Lot-Bumps in der Lotmenge und Höhe so bemessen sind, daß beim Zusammenlöten die Höhe der Lot-Bumps infolge der Benetzung an den gegenüberliegenden Kontaktflächen sich um mindestens die Differenz zwischen Höhe der Lot-Bumps und wirksame Höhe der Stützpunkte vermindert.

Durch den Umstand, daß die den Lot-Bumps gegenüberliegenden Kontaktflächen größer ausgebildet sind als die Grundflächen der Lot-Bumps bildet sich beim Verbinden eine konkave Lotkehle aus und es ergibt sich eine bessere Zugkraft des Lotes.

Verfahren nach der Erfindung sind dadurch gekennzeichnet, daß die Vorsprünge und/oder Vertiefungen durch anisotropes Ätzen oder auf galvanotechnischem Wege hergestellt werden.

Anhand der Figuren wird jetzt die Erfindung näher erläutert.

Figur 1 zeigt, wie dem Substrat neben Lot-Bumps erfindungsgemäß Vorsprünge angebracht sind.

In Figur 2 ist ein Querschnitt durch Substrat und Bauelement nach dem Verlöten dargestellt.

Figur 3 und 4 zeigen mögliche Anordnungen von Lot-Bumps und Vorsprüngen nach der Erfindung.

Figur 5 zeigt eine Weiterbildung der Erfindung mit Vorsprüngen und Vertiefungen.

Figur 6 zeigt die Schritte eines Verfahrens zur Herstellung von erfindungsgemäßen Vorsprüngen auf Bauelement und Substrat.

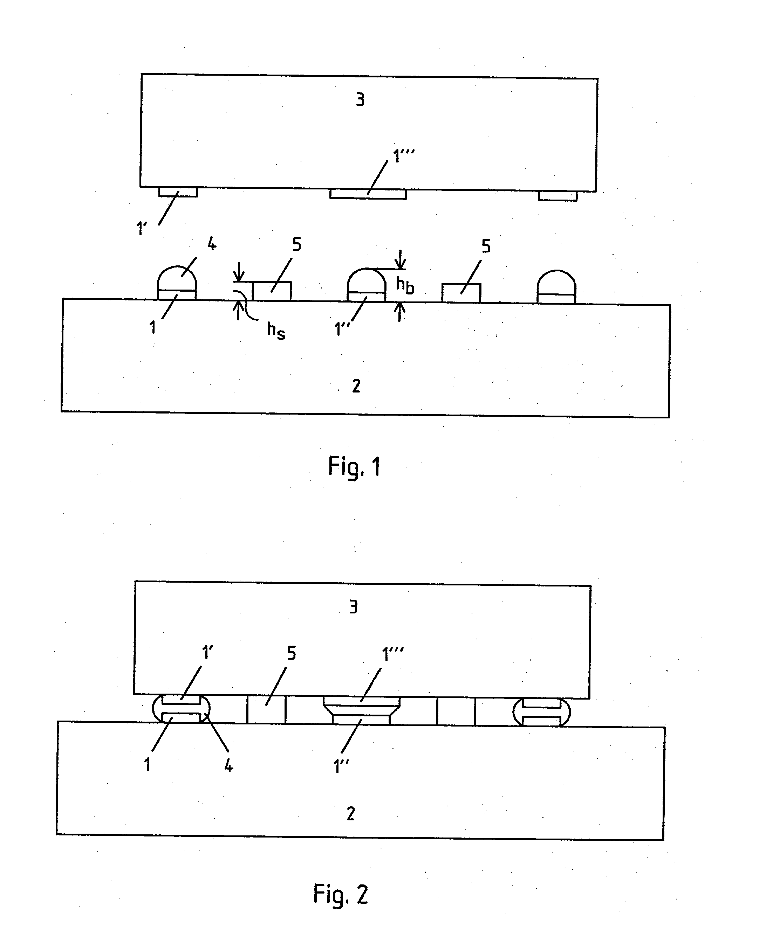

In Figur 1 ist zu sehen, wie neben den von der einschlägigen Technik her bekannten Kontaktierflächen 1 auf dem Substrat 2 und den Kontaktierflächen 1' auf dem Bauelement 3 sowie den Lot-Bumps 4 es erfindungsgemäß entweder auf dem Substrat oder auf dem Chip Stützpunkte 5 gibt, deren Höhe $h_s$ zweckmäßig geringer gewählt wird als die Höhe $h_b$ der Lot-Bumps. Bei der Montage wird das Bauelement 3 so auf das Substrat 2 gelegt, daß seine Kontaktflächen 1' gerade auf den Lot-Bumps 4 zu liegen kommen. Beim Aufschmelzen des Lotes wird das Bauelement 3 durch die Oberflächenspannung des flüssigen Lotes lateral justiert, sodaß die Kontaktflächen 1' über den Kontaktflächen 1 zu liegen kommen. Die Lotmenge und der Höhenunterschied $h_b$ der Lot-Bumps und $h_s$ der Stützpunkte ist nach der Erfindung so bemessen, daß die Höhe $h_b$ der Lot-Bumps infolge der Benetzung an den Kontaktflächen 1' sich mindestens um den Betrag $h_b - h_s$ vermindert. Das Bauelement sitzt dann auf den Stützpunkten 5 in einem

durch deren Höhe $h_s$ genau vorgegebenen Abstand vom Substrat auf. Das ist in Figur 2 gezeigt.

Außerdem wird zweckmäßigerweise ein Lot gewählt, das neben seiner plastischen Verformbarkeit noch eine elastische Verformbarkeit aufweist, die so groß ist, daß während des Abkühlvorgangs von der Erstarrungstemperatur bis zur Raumtemperatur eine elastische Dehnung eingefroren wird, die ausreichend ist, um ein Abheben des Bauelements von den Stützpunkten infolge einer Wärmeausdehnungsdifferenz zwischen Lot-Material und Stützpunkt-Material bei Erwärmung innerhalb des zulässigen Betriebstemperaturbereiches zu verhindern. Hierzu geeignet sind verhältnismäßig hoch schmelzende Lote mit einem großen elestischen Verformungsbereich und geringer Duktilität wie zum Beispiel Gold/Germanium, Gold/Silizium oder Gold/Zinn. In Figur 2 ist an einer Kontaktfläche 1''' dargestellt, wie sich eine konkave Lotkehle ausbildet, wenn die Kontaktfläche 1''' größer ist als die Grundfläche 1'' des korrespondierenden Lot-Bumps.

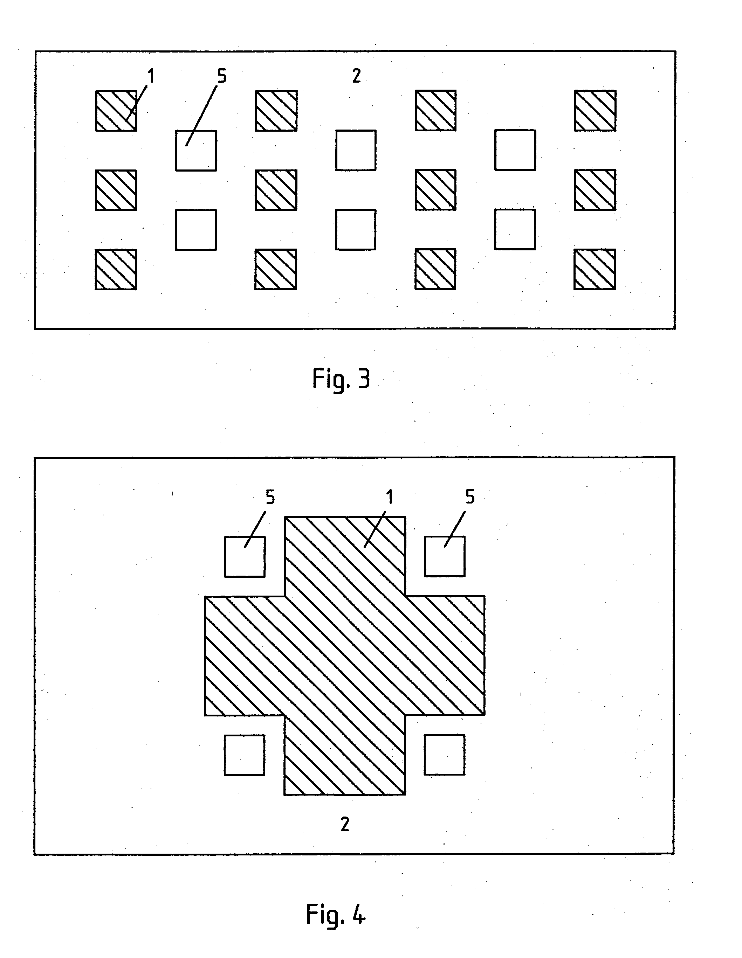

Die Ausgestaltung und Verteilung der Stützpunkte und der Kontaktflächen ist in vielfältiger Weise möglich. Die Stützpunkte 5 und die Kontaktflächen 1 und 1' können beispielsweise aus in regelmäßigem Raster angeordneten Kreisen, Quadraten oder Rechtecken bestehen Figur 3. Wenn eine gute Wärmeleitung zwichen Bauelement und Substrat zur Ableitung der Verlustwärme erforderlich ist, so muß eine dichte bzw. großflächige Belegung der Grenzfläche mit der Kontaktfläche 1 bzw. 1' vorgesehen sein. Figur 4 zeigt als Beispiel ein Substrat 2, auf welchem eine Kontaktfläche 1 in Kreuzform aufgebracht ist, deren Ausdehnung dem Bauelementmaß entspricht. In den frei bleibenden Ecken des Kreuzes sitzen die Stützpunkte 5. Die Kontaktfläche 1 ist dabei so ausgebildet, daß unterhalb der Wärmequellen im Bauelement eine möglichst große und geschlossene Lötfläche zu liegen kommt. Bei Halbleiterlasern, die entlang der aktiven Zone eine nahezu linienförmige Wärmequelle besitzen, muß beispielsweise unterhalb der aktiven Zone ein Balken dieses Kreuzes liegen.

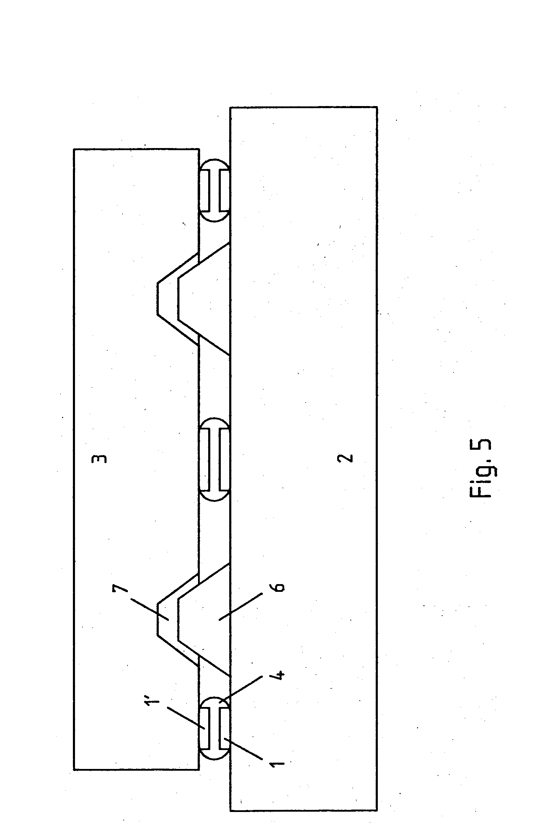

Eine Weiterentwicklung der erfinungsgemäßen Lösung ist in Figur 5 gezeigt. Hier werden, wie oben beschrieben, wieder das Bauelement 3 und das Substrat 2 durch die Oberflächenspannung des Lotes 4 zwischen den Kontaktflächen 1 und 1' zueinander gezogen. Durch die Stützpunkte 5 wird hier nicht nur eine Abstandsjustierung sondern auch eine laterale Justierung erreicht, die genauer und zuverlässiger ist als diejenige, die durch die Oberflächenspannung des Lotes bewirkt wird. Dazu sind die Stützpunkte 6 pyramidenförmig oder pyramidenstumpfförmig ausgebildet und ragen in entsprechende Vertiefungen 7 im Bauelement hinein, die ebenfalls pyramidenförmig oder pyramidenstumpfförmig sind und vorzugsweise den gleichen Böschungswinkel besitzen wie die Erhöhungen 5. Die Differenz der Basisdurchmesser der Erhöhungen 6 und der Vertiefungen 7 ergibt in Verbindung mit dem, Böschungswinkel die Eintauchtiefe und damit den hieraus resultierenden Abstand zwischen Substrat 2 und Bauelement 3. Die gegenseitige Lagebeziehung der Erhöhungen 6 zu den Vertiefungen 7 ergibt die laterale Ausrichtung zwischen Bauelement 3 und Substrat 2.

Solche pyramidenförmige Vertiefungen und Erhöhungen lassen sich besonderes präzise durch anisotropes Ätzen herstellen. Der Böschungswinkel ist dabei durch die Kristallstruktur vorgegeben und daher von höchster Präzision. Beispielsweise beträgt der Böschungswinkel von alkalisch geätzten (111)-Ebenen zur (100)-Oberfläche von einkristallinen Siliziumwafern

$$\alpha = \arctan \sqrt{2} = 54,74 \text{ Grad.}$$

Da die Lage und die Durchmesser der pyramidenförmigen Erhöhungen und Vertiefungen durch die Ätztechnik sehr genau bestimmt werden können und die Böschungswinkel durch die Kristallsturktur exakt vorgegeben sind, ist die Ausrichtung vom Bauelement zum Substrat in allen drei Koordinaten mit höchster Präzision festgelegt und unterliegt nicht mehr dem Einfluß unterschiedlicher Lotmengen und -beschaffenheiten.

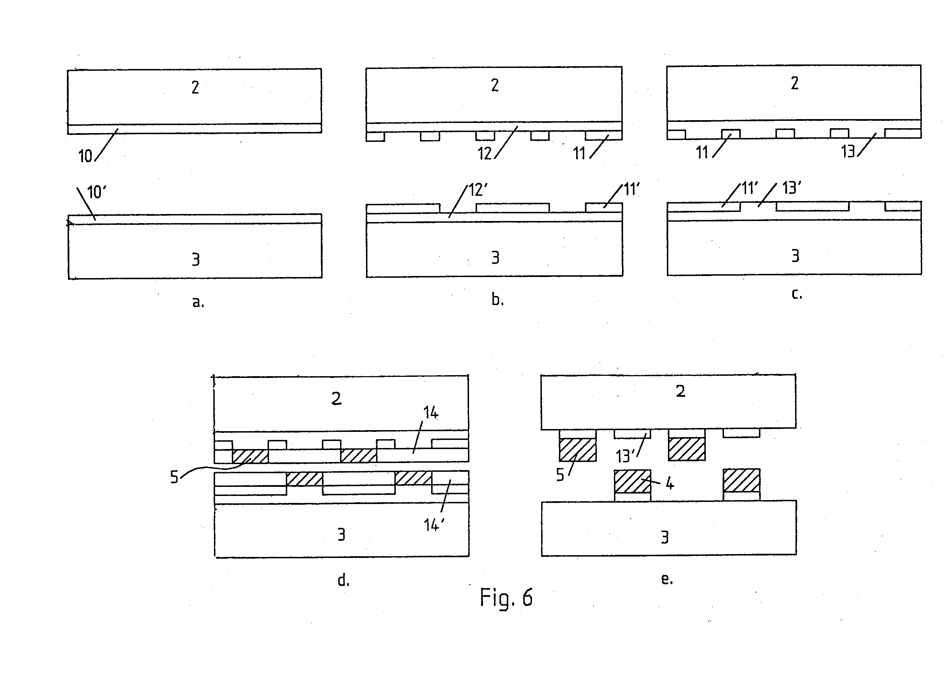

Zur Herstellung der in den Figuren 1-3 gezeigten Strukturen wird beispielhaft ein Verfahren vorgeschlagen, dessen einzelne Arbeitsschritte in Figur 6 dargestellt sind. Es sind selbstverständlich auch andere nach dem Stand der Technik bekannte Strukturierungsverfahren und auch andere Materialien geeignet. Die einzelnen Darstellungen zeigen das Substrat und das Bauelement auf deren Oberseite bzw. Unterseite zunächst durch Aufdampfen oder Sputtern eine dünne (ca. o,1 Mikrometer) Goldschicht 10 und 10' mit den erforderlichen und hier nicht gezeigten Haftschichten aufgebracht worden ist. Figur 6a. Die Schichtdicken sind nicht maßstäblich gezeichnet. Hierauf wird ein Fotoresist 11 und 11' aufgetragen, der an den Stellen, an denen die Kontaktflächen 1 und 1' zu liegen kommen sollen, belichtet und entwickelt wird, sodaß an diesen Stellen 12 und 12' die Goldschichten 10 und 10' freiliegen (siehe figur 6b).

Nun werden die Goldschichten 10 und 10' an diesen freigelegten Stellen 12 und 12' galvanisch selektiv verstärkt auf eine Dicke von ca. 1-2 Mikrometer. Die Figur 6c zeigt die verstärkte Goldschicht 13 bzw. 13', die bis zur Höhe des Resists 11, 11' aufgewachsen ist. Auf die durch die Oberfläche des Resists 11, 11' und der verstärkten Goldschicht 13, 13' gebildeten ebenen Flächen wird ein zweiter dickerer Resist, vorzugsweise ein Festresist 14, 14', aufgebracht. Die Dicken dieser Festresiste 14 bzw. 14' sind so groß wie die Höhen $h_s$ der herzustellenden Stützpunkte 5 bzw. $h_b$ der Lot-Bumps 4. Da die Resiste 14 und 14' auf verschiedenen Trägern 2 bzw. 3 aufgebracht werden, so können auch die Dicken $h_s$ und $h_b$ unterschiedlich gewählt werden, wie es nach der Erfindung erforderlich ist. Der Resist 14 auf dem Substrat 2 wird nun an den Stellen 15 belichtet und entwickelt, an denen die Fußpunkte der Stützpunkte 4 liegen sollen. Der Resist 14' auf dem Bauelement 3 wird dort (16) belichtet und entwickelt, wo die Fußpunkte der Lot-Bumps 4 liegen sollen. Durch die so entstandenen Öffnungen im Resist 14 bzw. 14' werden nun die Stützpunkte 5 beispielsweise aus Nickel oder einem anderen geeigneten Material und die Lot-Bumps 4 selektiv galvanisch aufgewachsen. Die Fig. 6d zeigt die so erhaltenen Stützpunkte 5 und die Lot-Bumps 4, die noch vom Festresist 14 bzw. 14' und vom dünneren ersten Resist 11 bzw. 11' umgeben sind. Sie sind durch die dünne, zuerst aufgebrachte Goldschicht 10 bzw. 10' miteinander verbunden, sodaß eine elektrische Kontaktierung für die Galvanik vorhanden ist. Schließlich werden die Resiste 14 und 14' sowie 11 und 11' entfernt und die Goldschicht so lange geätzt, daß die Schichten 10 und 10' gerade verschwunden sind die zuvor galvanisch verstärkten Goldschichten 13 bzw. 13' jedoch zum größten Teil ihrer Dicke noch vorhanden sind, Figur 6e.

Die Lot-Bumps lassen sich alternativ anstatt durch galvanische Verstärkung auch durch Eintauchen in ein Lotbad herstellen, wenn deren Fußpunkte 13' zuvor, wie oben beschrieben, vorbereitet sind.

**Patentansprüche**

1. Anordnung aus Substat und Bauelment wobei das Bauelement mittels eines Lötvorganges mit dem Substrat fest verbunden wird, dadurch gekennzeichnet, daß entweder am Substrat (2) an der für das Bauelement (3) vorgesehenen Stelle oder am Bauelement (3) selbst oder sowohl am Bauelement (3) als auch am Substrat (2) Vorsprünge (5) vorgesehen sind, die sich außerhalb der zu verlötenden Flächen (1,1') befinden und deren Ausdehnung senkrecht zur Substratebene durch den zwischen Substrat und Bauelement geforderten Abstand ($h_s$) bestimmt ist.

2. Anordnung nach Anspruch 1, dadurch gekennzeichnet, daß an den den Vorsprüngen (6) gegenüberliegenden Stellen jeweils Vertiefungen (7) vorgesehen sind in die die Vorsprünge (6) eingreifen.

3. Anordnung nach Anspruch 1, dadurch gekennzeichnet, daß am vorbereiteten Substrat oder Bauelement angebrachte Lot-Bumps (4) in der Lotmenge und Höhe ($h_B$) so bemessen sind, daß beim Zusammenlöten die Höhe der Lot-Bumps infolge der Benetzung an den gegenüberliegenden Kontaktflächen sich um mindestens die Differenz zwischen Höhe der Lot-Bumps ($h_B$) und wirksame Höhe der Stützpunkte ($h_s$) vermindert.

4. Anordnung nach Anspruch 3, dadurch gekennzeichnet, daß die den Lot-Bumps gegenüberliegenden Kontaktflächen größer ausgebildet sind als die Grundflächen der Lot-Bumps.

5. Verfahren zur Herstellung eines Bauelementengehäuses oder eines Substrats für eine Anordnung nach Anspruch 1 oder 2, dadurch gekennzeichnet, daß die Vorsprünge (5,6) und/oder Vertiefungen (7) durch anisotropes Ätzen hergestellt werden.

6. Verfahren für die Herstellung eines Bauelementegehäuses oder eines Substrats für eine Anordnung nach Anspruch 1, d.g.,d. die Vorsprünge (5) auf galvanotechnischem Wege ergestellt werden.

Fig. 1

Fig. 2

Fig. 3

Fig. 4

Fig. 5

Fig. 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 248 566 (AMERICAN TELEPHONE & TELEGRAPH COMPANY)<br>* Spalte 9, Zeile 21 - Spalte 10, Zeile 28; Figuren 4, 5 * *<br>Spalte 10, Zeile 37 - Spalte 11, Zeile 4; Figuren 9, 18 *<br>– – – | 1-4 | H 01 L 21/60<br>H 01 L 23/13 |
| X | EP-A-0 312 217 (AMERICAN TELEPHONE & TELEGRAPH COMPANY)<br>* Spalte 3, Zeile 9 - Spalte 5, Zeile 41; Figuren 1-5 *<br>– – – | 1,2,5 | |
| X | IBM TECHNICAL DISCLOSURE BULLETIN. vol. 23, no. 5, Oktober 1980, NEW YORK US Seiten 2156 - 2158;<br>A.F.GALLOWAY ET AL.: "Stand-offs for chip alignment as well as controlled collapse in chip joining"<br>* das ganze Dokument *<br>– – – | 1 | |
| X | IBM TECHNICAL DISCLOSURE BULLETIN. vol. 16, no. 3, August 1973, NEW YORK US Seite 767 V.D.COOMBS: "Chip mounting with prestretched joints"<br>* das ganze Dokument *<br>– – – | 1-3 | |
| A | IBM TECHNICAL DISCLOSURE BULLETIN. vol. 21, no. 11, April 1979, NEW YORK US Seite 4494 E.BERNDLMAIER: "Dummy pads for reduced thermal resistance"<br>* das ganze Dokument *<br>– – – – – | 1-6 | **RECHERCHIERTE SACHGEBIETE (Int. Cl.5)**<br><br>H 01 L<br>H 05 K |

Der vorliegende Recherchenbericht wurde für alle Patentansprüche erstellt

| Recherchenort | Abschlußdatum der Recherche | Prüfer |
|---|---|---|
| Berlin | 02 September 91 | LE MINH I |